# EUROPEAN PATENT APPLICATION

(11) **EP 2 233 933 A2**
(43) Date of publication of application: **29.09.2010**
(21) Application number: 10157836.7
(22) Date of filing: 25.03.2010
(51) Int. Cl.: G01R 15/20

(54) **Wireless Clamp-On Current Probe**

(30) Priority: 09.03.2010 US 720055; 26.03.2009 US 211143 P
(71) Applicant: Tektronix, Inc., Beaverton, OR 97077-0001 (US)
(72) Inventor: Cantave, Guilford, L, Orlando FL 32817 (US); Franceschini, Steven, M, Casselberry FL 32707 (US)
(74) Representative: Brinck, David John Borchardt

(57) **Abstract**

A Wireless Clamp-on Current Probe and an embedded system which includes a digital RF transceiver allows for remote test and measurement equipment to receive data from a current probe without regard to cabling issues such as size, physical wear, weight, cost, electrical noise, losses and more. Such a current probe may be used in environments and situations not previously explored. The probe may be controlled and queried by wired serial communication means or by means of an integrated radio frequency (RF) transceiver. The RF transceiver may utilize a proprietary communication protocol or a standard wireless communication protocol such as ZigBee, Bluetooth or any of the IEEE communication standards.

## Description

### Cross Reference to Related Patent Applications

This application claims priority to United States Provisional Application Serial No. 61/211,143 filed on March 26, 2009, which is incorporated herein by reference in its entirety.

### Field of the Invention

The invention relates generally to an apparatus and method for measuring the magnitude of an electrical current. In particular, the apparatus and the method of the present invention provide measurement of electrical current by a clamp-on current probe.

### Background of the Invention

Clamp-on current probes are used to make noncontact current measurements of the current passing through a conductor without interrupting the electrical circuit being tested. Other methods of measuring current passing through a conductor include the use of shunt resistors. The drawbacks of using shunt resistors include but are not limited to inherent power losses, the need to interrupt the circuit path to insert the meter in-line, heat generation, and the absence of electrical isolation from the circuit under test. US Patent No. 7,362,086 (Dupuis, et al.) entitled, INTEGRATED CURRENT SENSOR, issued 22 April 2008, describes a variety of method for detecting current at a particular point in a circuit including utilizing coupled inductors for generating an output current responsive to a detected current.

U.S. patent 5,493,211 (Clifford Baker) entitled, CURRENT PROBE, issued 20 February 1996 and assigned to the same assignee as the current invention, describes a current probe employing a Hall Effect Sensor for measuring the current in a conductor.

Clamp-on current probes are normally connected to test equipment such as digital multimeters, oscilloscopes, data acquisition units, power meters and other various instruments using banana jacks or other forms of cabling. Some clamp-on current probes are totally self contained and have visual indication of the magnitude of the current being measured, but do not have a means of connecting to external instruments.

Unfortunately, there are certain circumstances in which the use of such a wired interface between a current probe and a test and measurement instrument, or a data collection instrument, may be undesirable, or even dangerous to the user.

### Summary of the Invention

The apparatus and method of the present invention perform non-contact measurements of the current passing through a conductor without interrupting the electrical circuit being tested, and wirelessly transmit the measured data to a receiving unit. The apparatus of the present invention, when clamped around a conductor, can measure the current passing through the conductor and wirelessly transmit the data to a receiving unit. The apparatus of the present invention may transfer this data to a data acquisition system, a test and measurement instrument or other host apparatus, in which the receiving unit can be embedded. The information received by the receiving unit can be made available on demand or can optionally be logged.

The wireless clamp-on current probe of the present invention combines a clamp-on current probe with an embedded system which includes an RF transceiver to enable stationary test equipment to connect to current probes, without regard to cabling issues such as size, physical wear of cables, weight, cost, electrical noise, losses and other issues related to physical connections. The apparatus and method of the present invention also permit the use of current probes in environments and situations not previously possible.

The apparatus of the present invention may be controlled and queried by wired serial communication means or by an integrated radio frequency (RF) transceiver. The RF transceiver may utilize a proprietary communication protocol or a standard wireless communication protocol such as ZigBee, Bluetooth or any of the IEEE communications standards. The many configuration settings of the apparatus may be changed by the user by issuing commands to the apparatus from an established command set. The apparatus of the present invention may use digital processors for signal processing to perform all core functions. This enables the apparatus to add functionality in the form of modified firmware instead of modifying existing circuitry or adding further circuitry.

### Brief Description of the Drawings

FIGURE 1 is a basic high-level block diagram of the transmitter system of one embodiment of the invention.

FIGURE 2A is a schematic of the transmitter analog front end portion of one embodiment of the system of the invention.

FIGURE 2B is a schematic of the transmitter +2.5V voltage reference portion of one embodiment of the system of the invention.

FIGURE 2C is a schematic of the transmitter analog-to-digital (ADC) converter portion of one embodiment of the system of the invention.

FIGURE 2D is a schematic of the transmitter microcontroller portion of one embodiment of the system of the invention.

FIGURE 2E is a schematic of the transmitter +3.3V buck-boost DC-DC converter portion of one embodiment of the system of the invention.

FIGURE 2F is a schematic of the transmitter +3.3V rail on after delay portion of one embodiment of the system of the invention.

FIGURE 2G is a schematic of the transmitter -15V boost DC-DC inverter portion of one embodiment of the system of the invention.

FIGURE 2H is a schematic of the transmitter +15V boost DC-DC converter portion of one embodiment of the system of the invention.

FIGURE 2I is a schematic of the transmitter Lithium-Ion / Lithium-Polymer charge management controller portion of one embodiment of the system of the invention.

FIGURE 2J is a schematic of the transmitter digital RF transceiver portion of one embodiment of the system of the invention.

FIGURE 3A is the transmitter basic high-level firmware flowchart of one embodiment of the invention.

FIGURES 3B and 3C form a single table of the standard system commands which may be used to operate the unit.

FIGURE 4 is a basic high-level block diagram of the receiving system for one embodiment of the invention.

FIGURE 5A is a schematic of the receiver analog front end portion of one embodiment of the system of the invention.

FIGURE 5B is a schematic of the receiver +2.5V voltage reference portion of one embodiment of the system of the invention.

FIGURE 5C is a schematic of the receiver microcontroller portion of one embodiment of the system of the invention.

FIGURE 5D is a schematic of the receiver +3.3V regulators of one embodiment of the invention.

FIGURE 5E is a schematic of the receiver digital RF transceiver portion of one embodiment of the system of the invention.

FIGURE 6A is the receiver basic high-level firmware flowchart of one embodiment of the invention.

FIGURE 6B is a further table of the standard system commands which may be used to operate the unit.

FIGURE 7 is an isometric depiction of a wireless clamp-on current probe in accordance with the subject invention.

FIGURE 8 is an isometric depiction of a wireless clamp-on current probe receiver unit in accordance with the subject invention.

### Detailed Description of the Invention

The apparatus and method of the present invention can be used to make noncontact current measurements of the current passing through a conductor without interrupting the electrical circuit being tested, and tirelessly transmit the measured data to a receiving unit. The apparatus of the present invention can be clamped onto a conductor to measure the current passing through it and wirelessly transmit the measured current value to a receiver unit. This information can be made available on demand or optionally logged.

The apparatus of the present invention may include a variety of elements arranged in different combinations depending on the use of the apparatus. Such elements that may be found in the apparatus of the present invention include, but are not limited to, voltage regulators, precision voltage references, radio transceivers, battery charge management controllers, lithium batteries, microcontrollers, nonvolatile memory, analog-to-digital converters, Hall Effect sensors, instrumentation amplifiers, operational amplifiers and other elements that optimize the apparatus for particular uses..

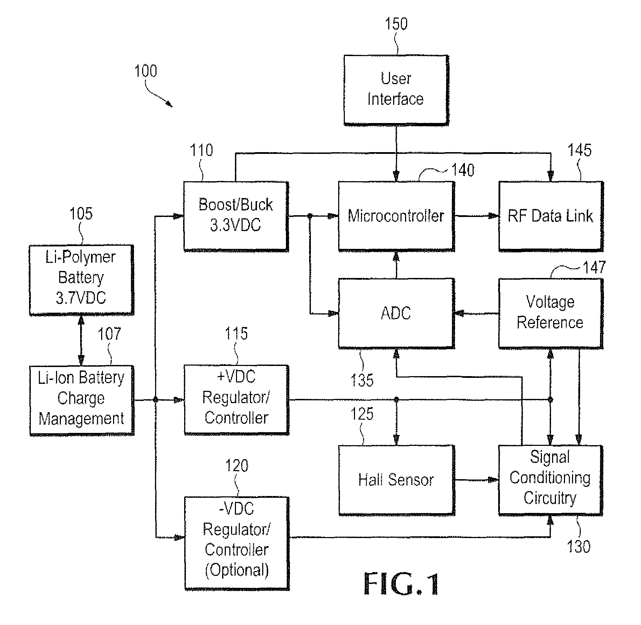

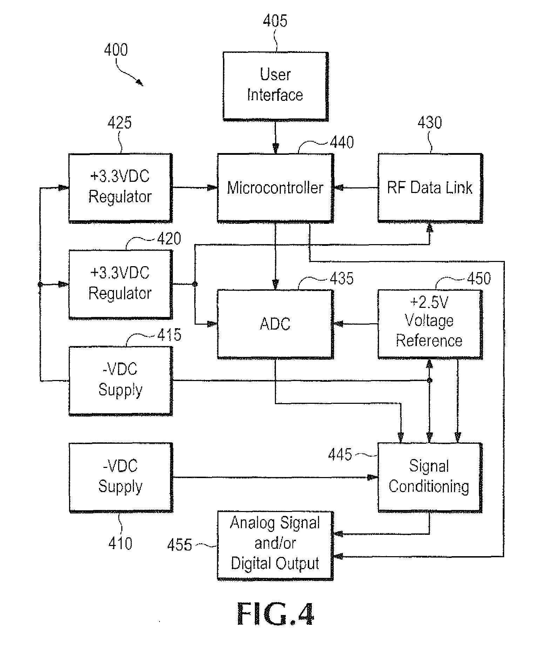

FIGURE 1 is a basic high-level block diagram of the transmitter system 100 of one embodiment of the invention which illustrates the relationship between all of the major sub-circuits of the system such as power, analog, digital and RF. The primary source of power for the transmitting unit is a lithium battery 105 which has a voltage span from 4,2V when fully charged to approximately 3.0V when depleted. Voltage regulators are employed to regulate the supply voltage from lithium battery **105,** because the voltages used by the subsystems need to be fixed at particular voltage levels. The apparatus of the present invention includes +3.3V, +15V and -15V switch-mode voltage regulators **110, 115, 120** which supply the required constant voltages to all of the subsystems, even as the battery voltage decreases while the unit is in use. A Hall Effect sensor 125 may be used as a transducer for converting the magnitude of a detected magnetic field generated by the current carrying conductor, to a representative voltage. A signal conditioning circuit 130 filters and scales the output voltage from the Hall Effect sensor to a magnitude which is appropriate for the input range of an ADC (analog-to-digital converter) 135. ADC 135 converts the output voltage from the signal conditioning circuitry into digital data. This digital data is applied to a Microcontroller 140 for processing and formatting and then sent serially to an RF data link 145 for wireless transmission to the receiving unit 400 (of FIGURE 4).

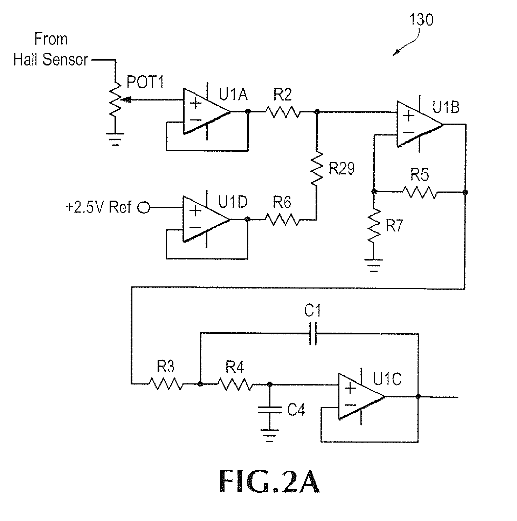

FIGURE 2A is a schematic of one embodiment of an analog front end of the wireless clamp-on current probe transmitter of the subject invention. Potentiometer POT1 is used as an attenuator for the single-ended output signal of Hall Effect sensor 125. Small mechanical multi-turn potentiometers may be used, but in a preferred embodiment, potentiometer **POT1** can be a solid state digital potentiometer which is more reliable.

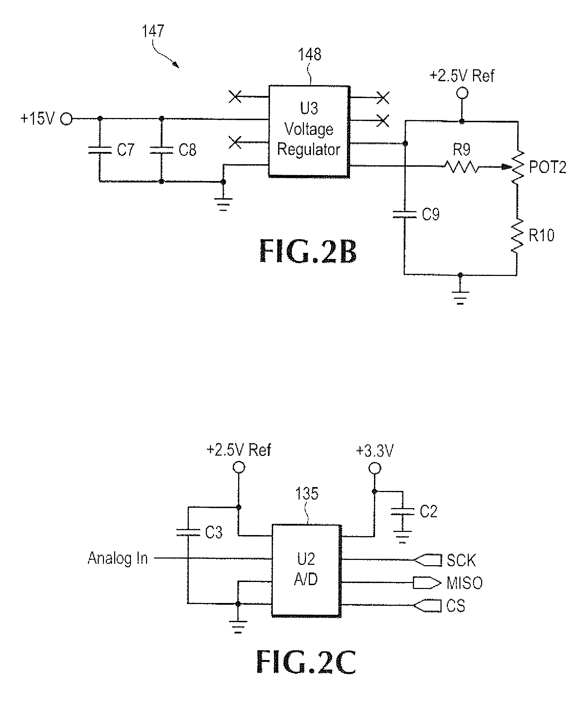

An operational amplifier (Op-amp) **U1A** is used to buffer the attenuated Hall Effect sensor signal received from the wiper terminal of **POT1.** An Op-amp **U1D** is used to buffer the output from a +2.5V voltage reference **147.** The output signals of Op-amps **U1A** and **U1D** are coupled to a further Op-amp **U1B** through a summing network composed of resistors **R2, R6,** and **R29.** Op-amp **U1B** and resistors **R5** and **R7** form an amplifier that is used to sum and scale the output signal of Op-amp **U1A** (i.e., the sensor signal), and the buffered +2.5V reference voltage from Op-amp **U1D** The summed output of Op-amp **U1B** is now a signal which has been scaled and offset adjusted to optimize the use of the voltage input range of ADC **135** (**U2** in FIGURE 2C). The output signal of amplifier **U1B** is coupled to a filter comprising resistors **R3, R4,** capacitors **C1** and **C4** and a further Op-amp **U1C.** Op-amp **U1C** is configured as a second order low-pass filter which is used to limit the bandwidth of the signal that is to be applied to the input terminal of ADC **135.**

FIGURE 2B shows details of +2.5V voltage reference source **147.** A voltage regulator **148** receives +15V at an input terminal and produces a regulated +2.5V voltage at its output terminal. Capacitors **C7** and **C8** filter the input voltage to eliminate unwanted noise. The regulated output voltage is applied to a voltage divider comprising resistors **R9** and **R10** and a potentiometer **POT2.** One skilled in the art will realize that potentiometer **POT2** may also be of the solid state type, mentioned above. Adjustment of potentiometer **POT2** causes the voltage developed at the **+2.5V Ref** output terminal to vary slightly. That is, the output of +2.5V voltage reference source **147** may be adjusted using **POT2** of to slightly adjust the offset of the analog output signal at the input of Op-amp **U1B** of FIGURE 2A.

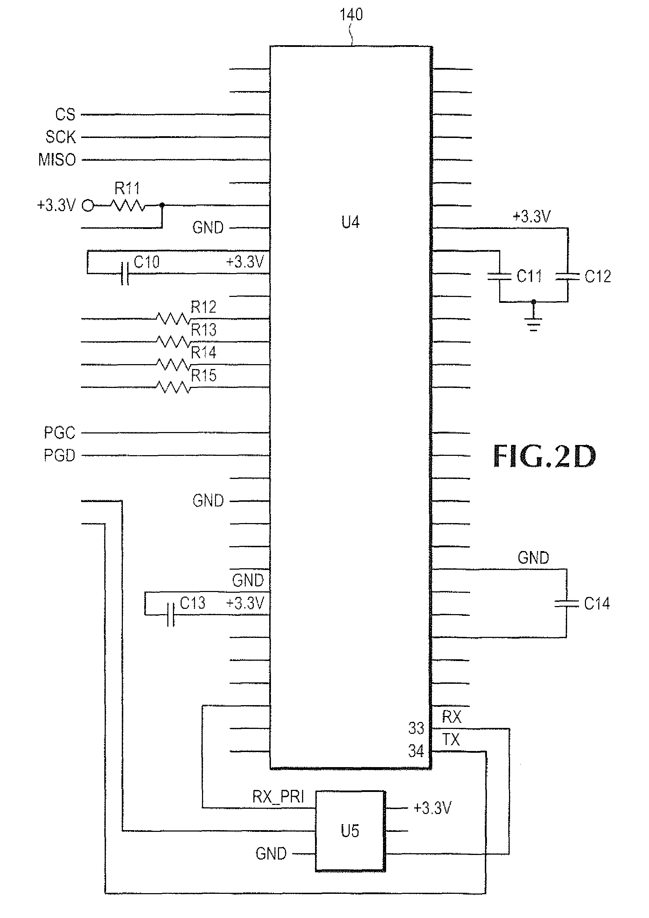

Referring to FIGURE 2C, ADC **135** is used to sample the conditioned output signal from the Hall Effect sensor **125** and convert it into 16-bit digital words which microcontroller **140** (**U4** in FIGURE 2D) can digitally process. Lower or higher resolution analog-to-digital converters could have been used, but the present cost and the resolution of a 16-bit ADC make it suitable for this application. Capacitors **C2** and **C3** filter the +3.3V supply and the +2.5V reference signal, respectively. ADC **135** may be, for example a LTC1864 manufactured by Texas Instruments.

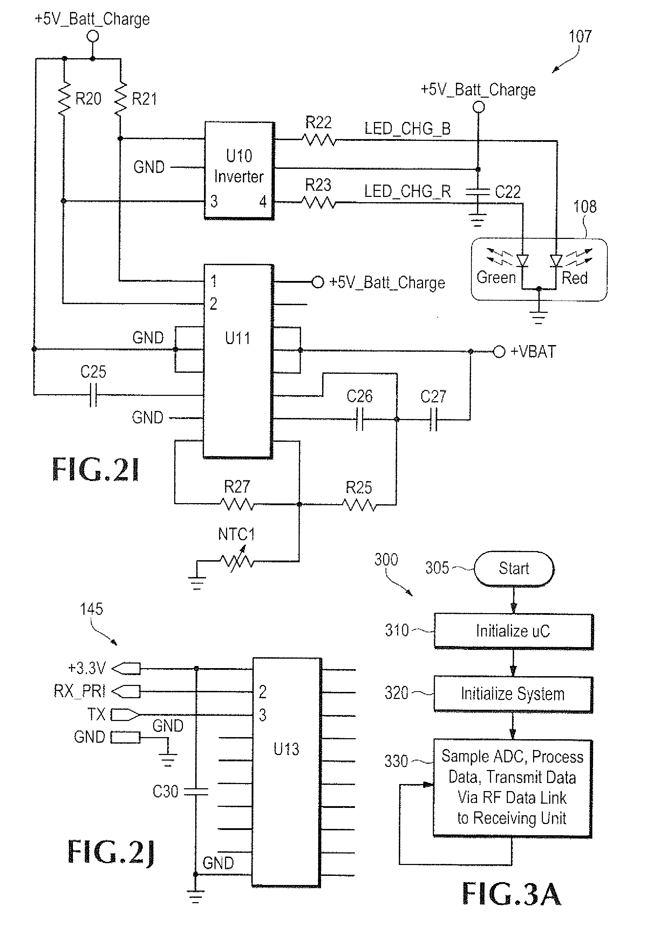

Referring to FIGURE 2D, microcontroller **140** controls all intelligent functions of the apparatus. All of the major integrated circuits onboard are designed to be controlled by and interfaced to a processor/microcontroller. The apparatus of the present invention can be designed to incorporate any of the various types of processors such as, but not limited to Complex instruction set computer (CISC), reduced instruction set computer (RISC), Harvard architecture, Von Neumann architecture and also the Modified Harvard architecture. A field programmable gate array (FPGA) or digital signal processor (DSP) also could have been used to implement the design. The preferred microcontroller has a small footprint, low pin count, ample program memory, low power consumption, integrated oscillator and rich set of peripherals and digital communication interfaces. Microcontroller **140** is responsible for polling the ADC at a regular time interval thus sampling the signal conditioned output from the Hall Effect sensor **125,** it is used to compute the magnitude of the current being measured based on the data acquired from ADC **135,** transmit current magnitude information to the system's RF transceiver **U13,** check the status of the system's battery, and interface with a host system to allow the end user to configure the system settings. Microcontroller **140** may be, for example, a DSPIC manufactured by Microchip Technology Inc. Single bus buffer gate/line driver **U5** isolates the received signal output from RF transceiver (**145** in FIGURE 2J) from reaching the microcontroller **140** receive pin during system startup. A suitable single bus buffer gate/line driver is the SN74AHCT1G126 manufactured by Texas Instruments.

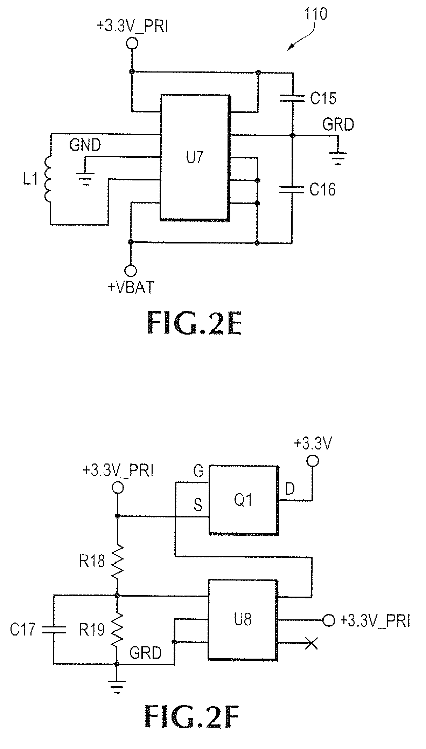

FIGURE 2E is a more detailed illustration of +3.3V buck/boost switch-mode voltage regulator **110.** A chip **U7** used to convert the 4.2V - 3.0V from lithium-ion battery **105** or from an external +5.0V supply, to a fixed +3.3V output voltage. A coil **L1** is coupled to chip **U7** and used in the switch mode regulation process. A capacitor **C16** filters the incoming battery voltage and a capacitor **C15** filters the +3.3V output voltage. This +3.3V "rail" (i.e., power supply level) is used to power microcontroller **140,** ADC **135,** and radio transceiver **U13.**

To prevent this switch-mode regulator from powering the previously mentioned circuits before the +3.3V output reaches steady-state, a "power-on-after-delay" circuit is implemented and is illustrated in FIGURE 2F. The output of +3.3V regulator **110** is connected to the source terminal **S** of **Q1,** which may be an FET transistor switch, and also to a resistor/capacitor network which consists **of R18, R19** and **C17.** When the output of the +3.3V regulator reaches steady-state and a period of time determined by the time constant of network **R18 C17** has passed, the voltage level at an input of a inverter **U8** is such that the output pin of inverter **U8** will transition from +3.3V to 0V. When the gate terminal **G** of **Q1** is low, the +3.3V **(+3.3V_PRI)** on its source terminal S will pass to the drain terminal **D** allowing the circuits on the +3.3V rail to be powered.

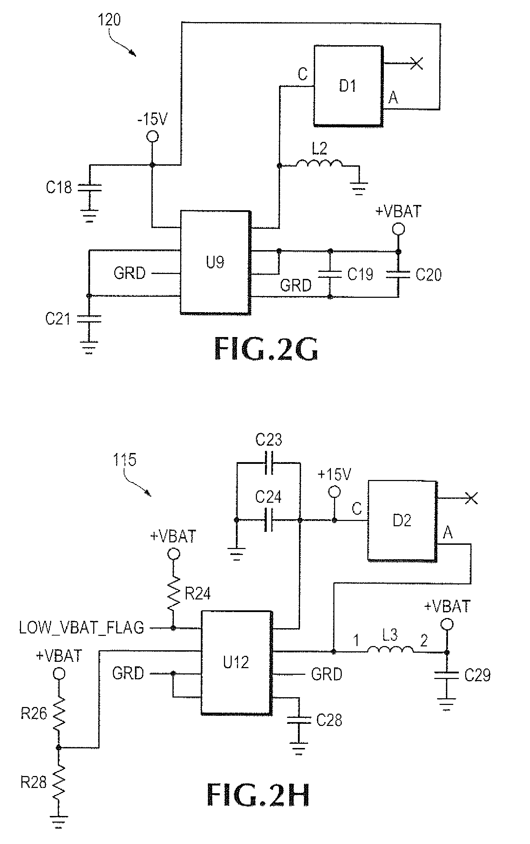

The switch-mode voltage regulators **120, 115** illustrated in FIGURE 2G and FIGURE 2H respectively, are used to bias the Hall Effect generator with +15.0V and -15.0V respectively. Referring to FIGURE 2G, an integrated circuit switch-mode negative voltage regulator **U9** receives the battery voltage from Li-Ion Battery Charge Management circuit **107,** and provides -15V at its output terminal. Capacitors **C19** and **C20** filter the incoming conditioned battery voltage to remove noise, and capacitor **C18** filters the generated -15V. Capacitor **C21** and Inductor **L2** are connected to terminals of integrated circuit switch mode voltage regulator **U9** to ensure proper operation thereof. **D1** is a Schottky diode which is used in conjunction with **U9** to generate the -15.0V.

Referring to FIGURE 2H, an integrated circuit switch-mode positive voltage regulator **U12** receives the battery voltage from Li-Ion Battery Charge Management circuit **107,** and provides +15V at its output terminal. Capacitors **C23** and **C24** filter the generated +15V. Capacitor **C29** and Inductor **L3** are connected to a terminal of integrated circuit switch mode positive voltage regulator **U12** to ensure proper operation thereof. **U12** in FIGURE 2H can also provide the system microcontroller with battery status. When the system battery is drained below a certain predetermined threshold as measured at the common node between resistors **R26** and **R28,** integrated circuit switch mode positive voltage regulator **U12** pulls an output pin low (i.e., sinks current through a pull-up resistor **R24**) thereby signaling to the system microcontroller that the battery should be recharged soon. **D2** is a Schottky diode which is used in conjunction with **U12** to generate the -15.0V.

FIGURE 2I shows additional details of Li-Ion Battery Charge Management circuit **107.** Referring to FIGURE 2I, an integrated circuit **U11** is used to manage the charging of the system Lithium-Ion/Polymer battery **105.** When an external supply of +5V is connected to the +5V_Batt_Charge terminal of unit **107,** integrated circuits **U10** and **U11** are energized. In operation, charge management controller **U11** receives the applied external +5V level and develops an appropriate voltage level to charge battery **105.**

The charge management controller **U11** initially checks the temperature of the battery via **NTC1** (a negative temperature coefficient thermistor) which in conjunction with **R27** forms a voltage divider circuit. Thermistor **NTC1** is mounted in close proximity to Li-Ion battery 105 in order to sense the temperature of battery **105.** As the battery temperature sensed by Thermistor **NTC1** increases, its resistance decreases, causing a change in the voltage divider ratio, and a corresponding change in the voltage developed at the common node of thermistor **NTC1** and resistor **R27,** which change of voltage is applied to an input terminal of charge management controller **U11.** If the temperature of the battery is within established limits, the charge cycle begins and pin number 2 of **U11** is pulled low and pin number 1 is pulled high (i.e., controller **U11** sinks current through a terminal coupled to pull-up resistor **R20** and does not sink current through a terminal coupled to pull-up resistor **R21**). One end of resistors **R20** and **R21** are coupled together and to a +5V source. Resistors **R20** and **R21** have respective second ends coupled to respective input terminals of an inverter **U10** for applying logic level signals thereto.

When pin number 3 of inverter **U10** is pulled to a logic level low, pin number 4 is set high which will bias on the green element of the dual color LED (green/red) **108,** causing current to flow through current limiting resistor **R23.** Illuminating the green portion of LED **108** signifies the battery is properly charging. The green portion of LED **108** will turn off when the charging cycle has successfully completed. If the temperature of the battery is too high, or too low, upon application of external power, the charge cycle is inhibited and pin number 2 of controller **U11** is pulled high (extinguishing the green portion of LED **108**) and pin number 1 alternates between high and low logic states at a rate of 1 Hz. This condition causes the red/green charge status LED **108** to blink red at a rate of 1 Hz. Capacitor **C22** is coupled to, and filters, the +5V_Batt_Charge level, and capacitor **C27** is coupled to, and filters, the battery voltage +VBAT. Capacitors **C25** and **C26** and resistor **R25** are coupled to controller **U11** and are used to ensure proper operation thereof.

FIGURE 2J shows additional detail of RF Data Link **145.** In one embodiment of the apparatus of the present invention, a Zigbee radio integrated circuit **U13,** illustrated in FIGURE 2J, is used to wirelessly transmit the magnitude of the current being measured by the wireless clamp-on current probe to a receiving unit at regular intervals or, only when queried. Communications between microcontroller **140** and Zigbee radio chip **U13** are handled via a simple logic-level universal asynchronous serial port interface (UART) on pins number 2 and 3 on Zigbee radio chip **U13** and on pins number 33 and 34 on microcontroller **140.** The interface is not only used to transmit data over the air to a receiving unit **400,** but is also used to configure the Zigbee radio so that it may properly communicate with other Zigbee radios in a personal area network. Zigbee radio integrated circuit **U13** may be a XB24-Z7WIT-004 manufactured by Digi International.

A basic firmware flowchart **300** of the wireless clamp-on current probe transmitter of the subject invention is illustrated in FIGURE 3A. The routine is entered at step 305 and progresses to step **310** wherein microprocessor **140** is powered-up. Upon system power up at step **320,** microcontroller **140** (**U4** of FIGURE 2D) initializes all of the input/output ports on the apparatus, initializes variables, reads and loads data coefficients from non-volatile memory, checks the battery status, and configures the Zigbee radio for use. At step **330,** the clamp-on current probe will sample the output of the Hall Effect sensor with ADC **135,** process the digitized data with microcontroller **140** and then, depending on the user configuration, the unit will then be on standby awaiting a command from the receiving unit or will check for an active receiver to send current measurements at a user defined regular interval or just idle until a current measurement sample is requested.

FIGURE 4 shows a basic high-level block diagram of the receiver system **400** of one embodiment of the invention, which illustrates the relationship between all of the major sub-circuits of the system such as power, analog, digital and RF. The primary sources of power for the receiving unit are ±15Vpower supplies **410, 415** provided by the end-user. Because the voltages used by the subsystems need to be fixed a particular voltages, the use of voltage regulators may be required. The apparatus of the present invention include two +3.3V linear voltage regulators **420, 425** which supply the required constant voltages to all of the digital subsystems. An RF Data Link **430** receives the data which was transmitted by the clamp-on current probe and relays it to the system microcontroller **440** serially.

Microcontroller **440** formats the incoming data and serially transmits it to a digital- to-analog converter (DAC) **435.** Microcontroller **440** is also responsible for handling a user interface **405.** DAC **435** converts the incoming digital data from the microcontroller **440** to an analog signal. A signal conditioning circuit **445,** in cooperation with a Voltage Reference circuit **450,** then filters, shifts and amplifies the analog signal from DAC **435** so that it now represents the magnitude of the current signal measured by the wireless clamp-on probe transmitter and outputs the analog signal at an output circuit **455** for use by the end-user. The end-user may also retrieve the output signal in digital form that is produced by microcontroller **440.**

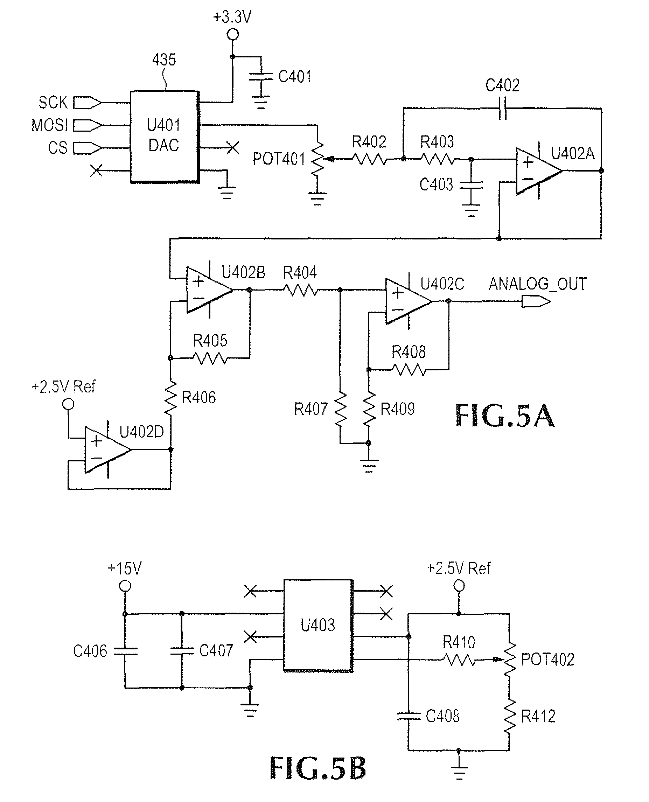

FIGURE 5A is a schematic of the analog signal conditioning circuitry **445** of the wireless clamp-on current probe receiver unit **400.** Potentiometer **POT401** is used as an attenuator for the output signal from DAC **435.** An Op-amp **U402A** in conjunction with resistors **R402, R403** and capacitors **C402** and **C403** are configured as a second order low-pass filter (anti-imaging filter) which is used to limit the bandwidth of the DAC output signal before applying it to an input terminal of a second Op-amp **U402B.** Op-amp **U402D** is used to buffer the output from the +2.5V voltage reference **450** which is used to add offset to the output signal from DAC **435.** The output of +2.5V voltage reference **450** may be adjusted using potentiometer **POT402** of FIGURE 5B to slightly adjust the offset of the analog output signal. Op-amp **U402B** is used to sum the outputs of **U402A,** the output signal of DAC **435,** and the output signal of Op-amp **U402D** (the buffered +2.5V reference voltage). Resistors **R404** and **R407** form a voltage divider for scaling the conditioned analog signal. An amplifier circuit, including Op-amp **U402C** and gain-setting resistors **R408** and **R409,** is used to amplify the output signal of Op-amp **U402B.** The output of Op-amp **U402C** is now a signal which has been scaled and offset and is the final analog output signal produced by receiving unit **400.**

FIGURE 5B shows details of +2.5V voltage reference source **450.** A voltage regulator **U403** receives +15V at an input terminal and produces a regulated **+2.5V** voltage at its output terminal. Capacitors **C406** and **C407** filter the input voltage to eliminate unwanted noise. The regulated output voltage is applied to a voltage divider comprising resistors **R410**and **R412** and a potentiometer **POT402.** One skilled in the art will realize that potentiometer **POT402** may also be of the solid state type, mentioned above. Adjustment of potentiometer **POT402** causes the voltage developed at the **+2.5V Ref** output terminal to vary slightly. That is, the output of +2.5V voltage reference source **450** may be adjusted using **POT402** of to slightly adjust the offset of the analog output signal at the input of Op-amp **U402D** of FIGURE 5A.

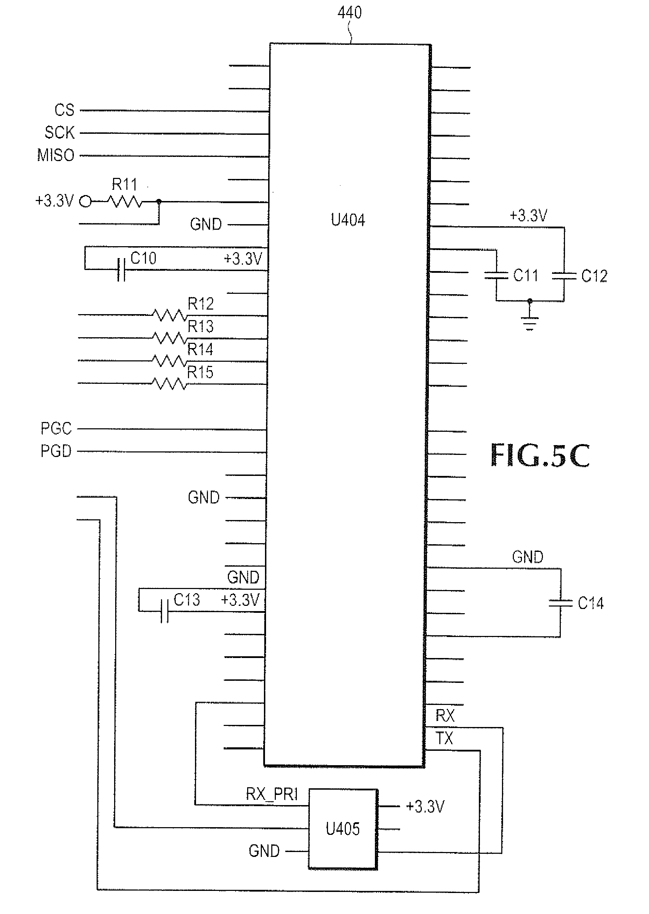

Microcontroller **440** in FIGURE 5C controls all intelligent functions of the apparatus. All of the major integrated circuits onboard are designed to be controlled by and interfaced to a processor/microcontroller. Microcontroller **440** in the receiving unit is responsible for receiving data from the Zigbee radio via its UART, providing the digital data stream to DAC **435,** controlling DAC **435** to provide an analog output signal to signal conditioning circuitry **445,** optionally outputting data digitally via serial interface, and employing its UART interface to allow the user to configure the unit externally. Microcontroller **440** may be, for example, a DSPIC manufactured by Microchip Technology Inc. **U405** of Figure 5C is a single bus buffer gate/line driver.

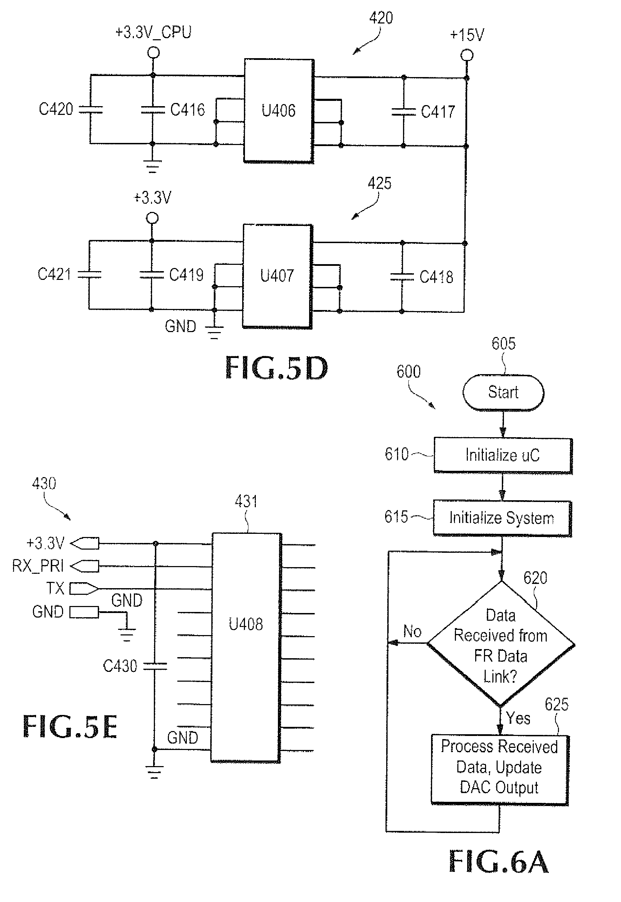

FIGURE 5D illustrates a pair of linear voltage regulators **420, 425** which are used to decrease the input voltage from the end user to a known and usable voltage. Voltage regulator **U406** is a +3.3V regulator which is used to power microcontroller **440** and DAC **435.** Voltage regulator **U407** is also a +3.3V regulator and is used to power the Zigbee radio **430.** Two discrete +3.3V voltage regulators are used instead of one to keep power dissipation for the voltage regulator integrated circuit at a minimum for each apparatus.

Referring to FIGURE 5E, the subject receiver embodiment **400** uses a Zigbee radio **430,** to wirelessly receive data indicative of the magnitude of the current being measured by the transmitting wireless clamp-on current probe. The apparatus can be configured so that the information is received/sent at regular intervals or only when queried. Communications between microcontroller **440** and Zigbee radio integrated circuit **431** are handled via a simple logic-level universal asynchronous serial port interface (UART) as described for the transmitting circuitry.

A basic firmware flowchart **600** for the wireless clamp-on current probe receiver 400 is illustrated in FIGURE 6A. The routine is entered at step **605** and advances to step **610** wherein microcontroller **440** is initialized. Upon system power up at step **615,** microcontroller **440** initializes all of the input/output ports on the apparatus, initializes variables, reads and loads data coefficients from non-volatile memory, and configures Zigbee radio **430** for use. Depending on the user configuration, the unit will then be on standby awaiting an interrogation command from the transmitting unit. If an interrogation command is received, the receiving unit will respond with a command received acknowledgement which allows for the transmitting unit to recognize that a receiving unit is active and ready to receive data. If the transmitting unit is set to stream data, the microcontroller of the receiving unit will receive a stream of data via UART from Zigbee radio **430** at step **620.** Microcontroller **440** in turn will control DAC **435** to update the analog output signal or optionally output the received data digitally via serial communication.

Calibration of the apparatus involves the adjustment of gain and offset potentiometers **POT1** and **POT2** on the transmitting apparatus **100** and also **POT401** and **POT402** of the receiving apparatus **400** in accordance with this particular embodiment. In a preferred embodiment, the potentiometers would be replaced by digital potentiometers or programmable current sources or a combination of both allowing for the calibration of the apparatus by automated means.

In other embodiments of the present invention, +5V components may be used, requiring +5V analog and digital voltage rails. This embodiment may require relatively more power to operate. Alternatively, +1.8V electronic components, which have very low power requirements, can be employed. In a preferred embodiment, the selected digital and mixed signal components used are all low power +3.3V devices, such as CMOS devices.

Temperature compensation can be incorporated into the apparatus of the present invention to increase the accuracy of the current measurements, especially when the apparatus is to be used in an environment which significantly differs in temperature from the environment in which it was calibrated. For example, the output voltage at a given magnetic field level of most Hall Effect devices decreases as temperature rises. The output of a temperature sensing apparatus (thermistor, thermocouple or dedicated temperature sensing integrated circuit) could be used to compensate for the temperature coefficient of the output of the sensing elements (Hall Effect apparatus in the invention as presently designed). This compensation could be performed in the analog circuitry by altering the gain of the amplifier, or the control current level. Temperature compensation may also be performed mathematically by the microcontroller section of the apparatus of the present invention by using temperature coefficient data for the sensing elements, whether typical empirically-derived values or actual measured values. The temperature sensor may be digital and may be controller and read by microcontroller **140.**

The implementation of the circuitry for the apparatus of the present invention may be accomplished in various ways. For example, the GaAs Hall Effect sensors could also be InAs or InSb sensors or, alternatively other magnetic senor types such as but not limited to, magneto-restive (MR/GMR), magneto-optical or coils may be used. Other communication schemes such as Ethernet or USB could be employed in addition to the preferred serial bus. The applications of the subject invention are not limited to the particular current measurement range limit, resolution, or accuracy described herein. Furthermore, the apparatus could be configured as a remote-monitoring apparatus, powered over Ethernet (POE), and controllable via the internet for application in any number of domestic, commercial or industrial locations.

A typical application in which the invention may be used is to wirelessly measure the current passing through a conductor on a distant apparatus using stationary test equipment. Another possible application is to measure and record the current consumption of multiple devices, which are separated by a distance of a few hundred feet using multiple wireless clamp-on current probes and one wireless current probe receiver connected to test and measurement equipment. Generally speaking, the typical application in which the invention may be used is bound only by the imagination of the end-user.

Communication with, and control of, the apparatus of the present invention may be achieved by use of a commercially available software language, for example but not limited to the variants of C, C++, BASIC, Fortran, LabView, TestPoint or HyperTerminal and a computer or controller which can send and receive serial communication signals or by other equipment with a serial port for communication. The communication may be at TTL type digital or bipolar voltage levels commonly associated with RS-232C interfaces. The default message terminator when sending a command to the unit is a carriage return (0x0D) and the default message terminator sent by the unit is line feed and carriage return (0x0D, 0x0A). Communication may be by direct wired connection or in conjunction with RF or optical transceiver modules. There are four user selectable baud rates available. Miscellaneous data such as model number, serial number or firmware version of the unit in operation may be retrieved by the user.

The internal data logging function is also user-configurable for various timing intervals and retrieval of data. Control may be initiated through text based command strings or graphical interfaces such as buttons or check boxes, limited only by the host system's particular programming language or hardware capabilities. The data received from the unit may be displayed numerically, graphically or stored in external memory of the host apparatus.

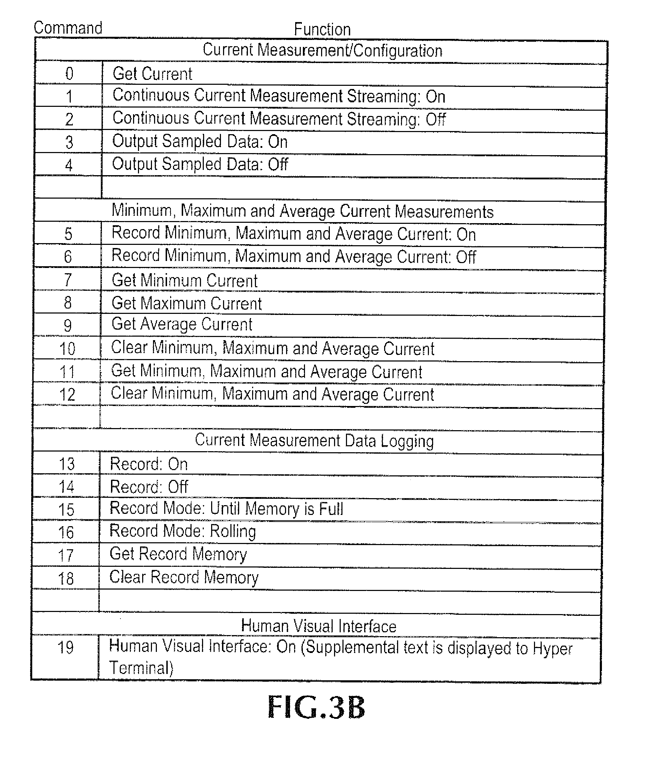

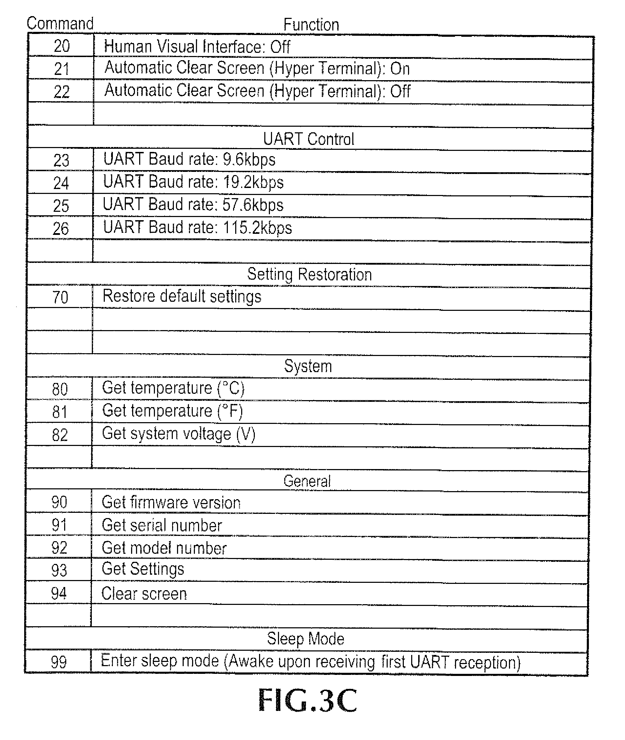

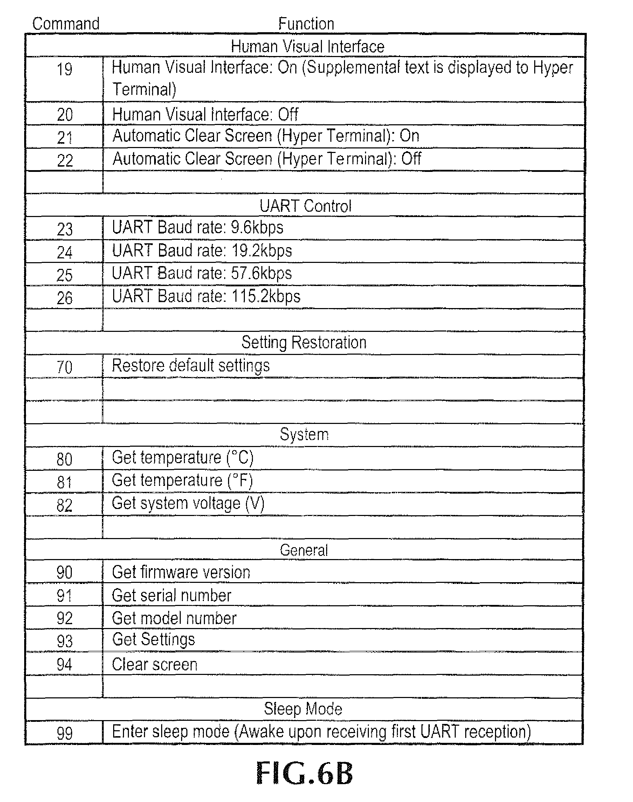

Communication may be achieved by use of a standard command set which may be expanded as future needs arise. Numeric commands are sent to the unit to change operating modes or to retrieve information back to the host. A command to clear the screen is included specifically for use with Microsoft HyperTerminal program. Other commands used for calibration are proprietary to the factory. This prevents the user from accidentally changing or corrupting the calibration of the unit. A standard user command set is described in FIGURES 3B, 3C and 6B.

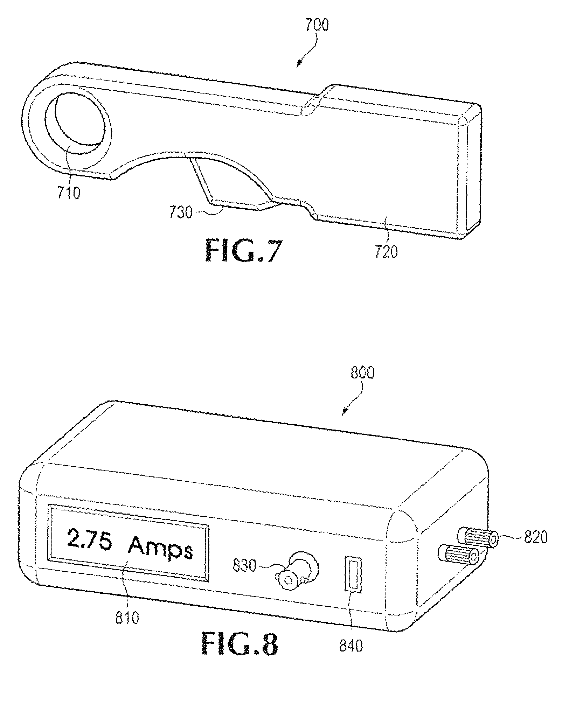

A perspective view of an embodiment of the clamp-on wireless current probe **700** of the subject invention is shown in FIGURE 7, wherein a current carrying wire (not shown) passes through an aperture **710** in probe body **720** for measurement of the magnitude of the current.

A trigger **730** on probe body **720** is depressed by an end-user to open the aperture and place the apparatus around a conductor which is carrying a current that is to be measured. While the probe body **720,** shown in FIGURE 7, is suitable for use with the subject invention, one skilled in the art will realize that other suitable arrangements are equally usable.

A perspective view of a housing **800,** suitable for use as an enclosure for the receiver **400** of the subject invention, is shown in FIGURE 8. Receiver **400** may include a display **810** for displaying an indication of the current measured by Clamp-on Wireless Current Probe **700.** Receiver **400** may also have one or more of a variety of connectors, such as: banana jacks **820,** a BNC terminal **830,** a USB terminal **840,** or the like, for communicating measurements and setup data between receiver **400** and an external test and measurement instrument or an external computer (not shown). While the shape of enclosure **800** of FIGURE 8 is suitable for use with the subject invention, one skilled in the art will readily understand that other suitable enclosures may be used.

The conjunctive article "or" as used herein, is used in the inclusive-or sense (i.e., one or the other or both). Moreover, it is intended to convey the meaning that either alternative is sufficient, and that all stated alternatives do not have to be present.

The embodiments described herein are for purposes of explanation, and are not intended to be limiting in any way. The subject invention is intended to be limited only by the following claims.

## Claims

1. A wireless clamp-on current probe and receiver system, comprising:
a wireless clamp-on current probe assembly, including:
a battery supplying power to said wireless clamp-on current probe;
a voltage regulator coupled to said battery and producing a power supply voltages at an output terminal;
a transducer, responsive to a magnetic field, for producing a signal representative of current conveyed by a conductor under test;
signal conditioning circuitry for filtering said signal representative of said current to produce a conditioned signal;
an analog-to-digital converter for sampling said conditioned signal to produce digital signal samples;
a microcontroller controlling said analog to digital converter and for processing said digital signal samples; and
a radiofrequency data link for communicating between said Microcontroller and a receiver unit, said radio frequency data link operating under control of said microcontroller; and
said receive unit, said receiver unit including:
a radio frequency receiver for receiving said digital data signal samples from said probe;
a microcontroller coupled to said radio frequency receiver for receiving and processing said digital data signal samples;
a digital-to-analog converter for converting said processed digital signal samples to an analog waveform representative of the current conveyed by said conductor under test, said digital-to-analog converter operating under control of said microcontroller;
signal conditioning circuitry coupled to the output of said digital-to analog converter for receiving and filtering said analog waveform; and
an output terminal for providing said filtered analog waveform to an external test and measurement instrument or to an external computer.

2. The wireless clamp-on current probe and receiver system of claim 1, wherein
said receiver includes a display device for displaying an indication of said magnitude of said current conveyed by said conductor under test.

3. The wireless clamp-on current probe and receiver system of claim 1, wherein
said receiver includes connectors for providing said filtered analog waveform to an external test and measurement instrument or to an external computer.

4. The wireless clamp-on current probe and receiver system of claim 1, wherein said voltage regulator is a switch-mode voltage regulator.

5. The wireless clamp-on current probe and receiver system of claim 4, wherein said transducer is a Hall Effect sensor.

6. The wireless clamp-on current probe and receiver system of claim 5, wherein said signal conditioning circuitry includes a user adjustable device for adjusting said offset.

7. The wireless clamp-on current probe and receiver system of claim 6, wherein said battery is a lithium-ion battery.

8. A method of making noncontact current measurements of current passing through a conductor without interrupting the electrical circuit being tested and wirelessly transmitting the measurements to a receiving unit, comprising the steps of:
clamping a wireless clamp-on current probe around said conductor;
detecting a magnetic field generated by said current carrying conductor;
generating a voltage representative of a magnitude of said current in response to detection of said magnetic field;
scaling a magnitude of said voltage;
sampling said voltage and producing digital data representing said samples;
formatting said digital data; and
sending the data to a receiving unit.

9. The method of claim 8, wherein the step of:
generating a voltage representative of a magnitude of said current is accomplished by use of a Hall Effect sensor.

10. The method of claim 9, wherein the step of formatting of said digital data is accomplished by use of a microcontroller.
